# EUROPEAN PATENT APPLICATION

(11) **EP 4 839 056 A1**
(43) Date of publication of application: **11.11.2026**
(21) Application number: 25802696.2
(22) Date of filing: 28.04.2025
(51) Int. Cl.: H10F 77/122

(54) **SILICON WAFER, SOLAR CELL, CELL MODULE, PHOTOVOLTAIC SYSTEM, AND SILICON ROD**

(30) Priority: 15.05.2024 CN 202410606385
(71) Applicant: Zhuhai Fushan Aiko Solar Energy Technology Co., Ltd., FushanIndustrial Park, Doumen District Zhuhai Guangdong 519000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Junkai, Jinhua, Zhejiang 322000 (CN); PAN, Junming, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/091793
(87) International publication number: WO 2025/237072

(57) **Abstract**

The present disclosure is suitable for the technical field of solar cells. Provided are a silicon wafer, a solar cell, a cell assembly, a photovoltaic system, and a silicon rod. The silicon wafer includes a central region and a corner edge region. A conduction type of the central region is an N type, and a conduction type of the corner edge region is a P type. Therefore, since the conduction type of the central region is the N type, and the conduction type of the corner edge region is the P type, in a process of manufacturing a solar cell based on the silicon wafer, contamination of copper ions to an edge of the silicon wafer can be withstood by using the P-shaped corner edge region, thereby reducing compounding caused by the contamination of the copper ions to the edge of the silicon wafer. Furthermore, a **PN** junction can be formed in the silicon wafer, and after the solar cell is manufactured, a better field passivation effect can be formed in the solar cell, thereby facilitating carrier transport. **In** this way, the photoelectric conversion efficiency of the solar cell manufactured based on the silicon wafer is improved.

## Description

### Cross-Reference to Related Application

This application claims priority to Chinese Patent Application No. 202410606385.X filed on May 15, 2024 and entitled "Silicon Wafer, Solar Cell, Cell Assembly, Photovoltaic System, and Silicon Rod", the disclosure of which is hereby incorporated by reference in its entirety.

### Technical Field

The present disclosure relates to the technical field of solar cells, and in particular, to a silicon wafer, a solar cell, a cell assembly, a photovoltaic system, and a silicon rod.

### Background

A solar cell converts sunlight into electric energy, and is generally made by a silicon wafer. The silicon wafer is an N-type silicon wafer or a P-type silicon wafer. In the related art, during the manufacturing of the solar cell, an edge of the silicon wafer is susceptible to metal ion contamination, especially copper ion contamination. Copper ion contamination greatly increases the compounding of the N-type silicon wafers, but has a small impact on the P-type silicon wafers. Based on this, how to reduce an adverse effect of copper ion contamination on an edge of the silicon wafer becomes an urgent problem to be solved.

### Summary

The present disclosure provides a silicon wafer, a solar cell, a cell assembly, a photovoltaic system, and a silicon rod, so as to solve the technical problem of how to reduce an adverse effect of copper ion contamination on an edge of a silicon wafer in the related art.

The present disclosure is implemented in this way. The silicon wafer of the embodiments of the present disclosure includes a central region and a corner edge region. A conduction type of the central region is an N type, and a conduction type of the corner edge region is a P type.

Specifically, a doping element of the central region includes an N-type doping element, and the N-type doping element includes at least one element in a fifth main group element and a sixth main group element.

Specifically, a doping element of the corner edge region includes a P-type doping element, and the P-type doping element includes at least one element in a third main group element.

Specifically, the silicon wafer includes a side edge region. The side edge region is located between two adjacent corner edge regions, and a conduction type of the side edge region is a P type.

Specifically, the a surface of the central region in a thickness direction of the silicon wafer is a circle, a center of the circle is a central point of the silicon wafer, and a radius of the circle is 1/5-1/2 of a side length of the silicon wafer.

Specifically, the corner edge region includes a first corner side and a second corner side, a length of the first corner side is 1/100-1/2 of a side length of the silicon wafer, and a length of the second corner side is 1/100-1/2 of the side length of the silicon wafer.

Specifically, a ratio of resistivity of the corner edge region to resistivity of the central region is greater than or equal to 1.2.

Specifically, resistivity of the central region is greater than or equal to 10 Ω▪cm.

Specifically, resistivity of the corner edge region is greater than or equal to 100 Ω▪cm.

Specifically, an acceptor impurity concentration of the corner edge region is less than an acceptor impurity concentration of the central region, and is less than a donor impurity concentration of the central region.

Specifically, a ratio of an acceptor impurity concentration of the central region to an acceptor impurity concentration of the corner edge region is 1.01-10.

Specifically, an acceptor impurity concentration of the corner edge region is less than or equal to 10¹⁵ atoms/cm³.

Specifically, the silicon wafer includes a transition region. The transition region is located between the central region and the corner edge region, resistivity of the transition region is greater than resistivity of the central region, and the resistivity of the transition region is greater than resistivity of the corner edge region.

Specifically, the resistivity of the transition region is greater than or equal to 1000 Ω▪cm.

Specifically, doping elements of the central region and the corner edge region all includes P-type doping elements and N-type doping elements. A doping concentration of the N-type doping elements in the central region is greater than a doping concentration of the P-type doping elements in the central region, and a doping concentration of the P-type doping elements in the corner edge region is greater than a doping concentration of the N-type doping elements in the corner edge region.

A slope absolute value of a concentration curve of the N-type doping element is greater than a slope absolute value of a concentration curve of the P-type doping element.

A horizontal coordinate of the concentration curve of the N-type doping element is a distance between a test position of the silicon wafer and a central point of the silicon wafer, and a vertical coordinate is a concentration of the N-type doping element in the test position; and a horizontal coordinate of the concentration curve of the P-type doping element is the distance between a test position and the central point of the silicon wafer, and a vertical coordinate is a concentration of the P-type doping element in the test position.

Specifically, the slope absolute value of the concentration curve of the N-type doping element and the slope absolute value of the concentration curve of the P-type doping element meet the following formula: $\frac{2}{\sqrt{2} a} \left({N}_{1}-{P}_{1}\right) < {K}_{1} - {K}_{2} < \frac{32}{\sqrt{2} a} \left({N}_{1}-{P}_{1}\right) .$

Where a is a side length of the silicon wafer, N₁ is the doping concentration of the N-type doping element, P₁ is the doping concentration of the P-type doping element in the central region, K₁ is the slope absolute value of the concentration curve of the N-type doping element, and K₂ is the slope absolute value of the concentration curve of the P-type doping element.

The present disclosure further provides a solar cell, which is manufactured based on any one of the above silicon wafers.

The present disclosure further provides a cell assembly, including the above solar cell.

The present disclosure further provides a photovoltaic system, including the above cell assembly.

The present disclosure further provides a silicon rod, including a central region and a surface skin. A conduction type of the central region is an N type, and a conduction type of the surface skin is a P type. Any one of the above silicon wafers is formed by cutting the silicon rod.

Specifically, the central region is in a shape of a circular truncated cone or a cone, and in a direction from a head of the silicon rod to a tail of the silicon rod, a cross-sectional area of the central region decreases gradually.

In the silicon wafer, the solar cell, the cell assembly, the photovoltaic system, and the silicon rod of the embodiments of the present disclosure, since the conduction type of the central region is the N type, and the conduction type of the corner edge region is the P type, in a process of manufacturing a solar cell based on the silicon wafer, contamination of copper ions to an edge of the silicon wafer can be withstood by using the P-shaped corner edge region, thereby reducing compounding caused by the contamination of the copper ions to the edge of the silicon wafer. Furthermore, a PN junction can be formed in the silicon wafer, and after the solar cell is manufactured, a better field passivation effect can be formed in the solar cell, thereby facilitating carrier transport. In this way, the photoelectric conversion efficiency of the solar cell manufactured based on the silicon wafer is improved.

In the silicon rod of the embodiments of the present disclosure, since the conduction type of the central region is the N type, and the conduction type of the surface skin is the P type. Minority carrier lifetime is higher, the resistivity is uniform, and head and tail resistivity distribution of the silicon rod does not need to be taken into consideration, such that complete pull-out of silicon materials in a crucible is facilitated, crystal pulling efficiency is higher, and a retention rate of the crucible is lower.

Additional aspects and advantages of the present disclosure will be partially set forth in the following description, and in part will be apparent from the following description, or can be learned by practice of the present disclosure.

### Brief Description of the Drawings

Fig. 1 is a schematic structural diagram of a silicon wafer according to an embodiment of the present disclosure.
Fig. 2 is a schematic structural diagram of a silicon wafer according to an embodiment of the present disclosure.
Fig. 3 is a schematic structural diagram of a silicon wafer according to an embodiment of the present disclosure.
Fig. 4 is a schematic structural diagram of a silicon wafer according to an embodiment of the present disclosure.
Fig. 5 is a schematic diagram of doping concentration distribution of a silicon wafer according to an embodiment of the present disclosure.
Fig. 6 is a schematic structural diagram of a silicon rod according to an embodiment of the present disclosure.
Fig. 7 is a schematic structural diagram of a silicon rod according to an embodiment of the present disclosure.
Fig. 8 is a schematic structural diagram of a silicon rod according to an embodiment of the present disclosure.
Fig. 9 is a schematic structural diagram of a silicon rod according to an embodiment of the present disclosure.
Fig. 10 is a schematic structural diagram of a test piece formed by cutting the silicon rod in Fig. 9.

In the drawings:
Silicon wafer 10, Central region 11, Corner edge region 12, First corner side 121, Second corner side 122, Transition region 13, Side edge region 14, Silicon rod 100, Head 1001, Tail 1002, First test piece 1021, Second test piece 1022, Third test piece 1023, Fourth test piece 1024, Fifth test piece 1025, Sixth test piece 1026, and Surface skin 20.

### Detailed Description of the Embodiments

To make the objectives, technical solutions and advantages of the present disclosure clearer, the present disclosure is further described in detail with reference to the drawings and embodiments. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it should be understood that orientation or position relationships indicated by the terms such as "top", "bottom", "back", "front", and the like are based on orientation or position relationships shown in the accompanying drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In the present disclosure, unless otherwise explicitly specified and defined, a first feature being "over" or "below" a second feature can mean that the first feature and the second feature are in direct contact, or the first feature and the second feature are not in direct contact but are in contact through another feature therebetween. Moreover, the first feature being "over", "above", and "on" the second feature includes that the first feature is directly above or obliquely above the second feature, or merely means that the first feature has a larger horizontal height than the second feature. The first feature being "beneath", "under" and "below" the second feature including the first feature being right under or at an inclined lower portion of the second feature, or simply indicating that the horizontal height of the first feature is less than that of the second feature.

The following disclosure provides many different embodiments or examples for achieving different structures of the present disclosure. In order to simplify the present disclosure of the present disclosure, components and settings of specific examples are described below. Certainly, they are merely examples, and are not intended to limit the present disclosure. In addition, the present disclosure can repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art can be aware of the application of other processes and/or usage scenarios of other materials.

In the present disclosure, since the conduction type of the central region is the N type, and the conduction type of the corner edge region is the P type, in a process of manufacturing a solar cell based on the silicon wafer, in some implementations, contamination of copper ions to an edge of the silicon wafer can be withstood by using the P-shaped corner edge region, thereby reducing compounding caused by the contamination of the copper ions to the edge of the silicon wafer. Furthermore, in some implementations, a PN junction can be formed in the silicon wafer, and after the solar cell is manufactured, a better field passivation effect can be formed in the solar cell, thereby facilitating carrier transport. In this way, the photoelectric conversion efficiency of the solar cell manufactured based on the silicon wafer is improved.

### Embodiment 1

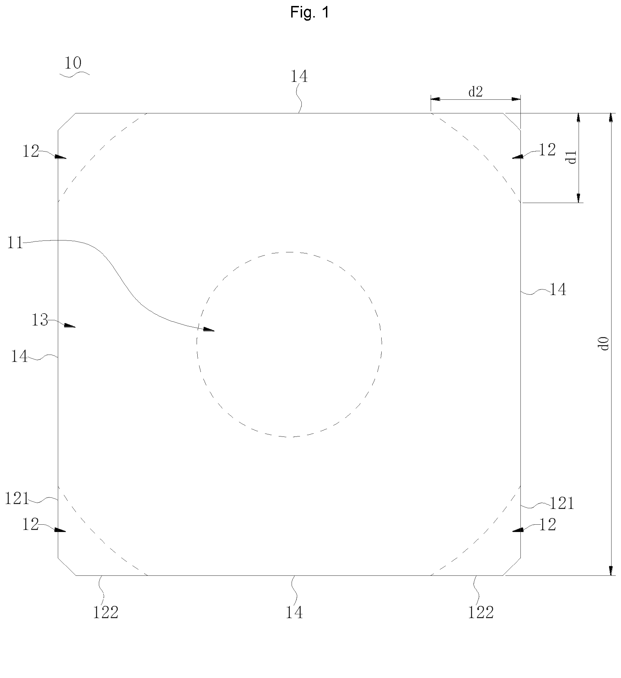

Referring to Fig. 1, Fig. 2, Fig. 3, and Fig. 4, a silicon wafer 10 in this embodiment of the present disclosure includes a central region 11 and a corner edge region 12. A conduction type of the central region 11 is an N type, and a conduction type of the corner edge region 12 is a P type.

In the silicon wafer 10 in this embodiment of the present disclosure, since the conduction type of the central region 11 of the silicon wafer 10 is the N type, and the conduction type of the corner edge region 12 is the P type, in a process of manufacturing a solar cell based on the silicon wafer 10, in some implementations, contamination of copper ions to an edge of the silicon wafer 10 can be withstood by using the P-shaped corner edge region 12, thereby reducing compounding caused by the contamination of the copper ions to the edge of the silicon wafer 10. Furthermore, in some implementations, a PN junction can be formed in the silicon wafer 10, and after the solar cell is manufactured, a better field passivation effect can be formed in the solar cell, thereby facilitating carrier transport. In this way, the photoelectric conversion efficiency of the solar cell manufactured based on the silicon wafer 10 is improved.

In the present disclosure, the silicon wafer 10 is a monocrystalline silicon wafer. It can be understood that, in other embodiments, the silicon wafer 10 is a polycrystalline silicon wafer, which is not limited herein.

In this embodiment, the silicon wafer 10 is square in shape, and four corners of the silicon wafer 10 all are chamfers. It can be understood that, in other embodiments, the silicon wafer 10 is in a rectangular, round, oval, triangular, or other shape. In some implementations, the corners of the silicon wafer 10 are in rounded, pointed, or other shapes. In some implementations, the plurality of corners of the silicon wafer 10 have the same shapes. In some implementations, the plurality of corners of the silicon wafer 10 have different shapes.

Specifically, the central region 11 refers to a space region that extends outward from a center line of the silicon wafer 10 in a thickness direction. The center line forms a central point on two surfaces of the silicon wafer 10 in the thickness direction. In the thickness direction of the silicon wafer 10, the central region 11 extends outward from the central point, as shown in Fig. 1, Fig. 2, Fig. 3, and Fig. 4. That is to say, the central region 11 is not formed on the surface of the silicon wafer 10; and the central region 11 is the space region having a thickness.

Specifically, the corner edge region 12 refers to a space region that extends from a cutting surface of the corner of the silicon wafer 10 to the center line of the silicon wafer 10. It can be understood that, a cross section of a silicon rod is in a circular shape, and the silicon wafer 10 forms the corner, such that it is necessary to cut the silicon rod to form the cutting surface at the corner. For example, when the corner of the silicon wafer 10 is the chamfer or a rounded corner, the cutting surface is a surface that is formed by cutting the chamfer or the rounded corner.

Further, as described above, the center line forms the central point on the two surfaces of the silicon wafer 10 in the thickness direction. In the thickness direction of the silicon wafer 10, the corner edge region 12 extends from an edge line of the corner of the silicon wafer 10 to the central point, as shown in Fig. 1, Fig. 2, Fig. 3, and Fig. 4. That is to say, the corner edge region 12 is not only formed on the surface of the silicon wafer 10; and the central region 12 is the space region having a thickness.

Specifically, a thickness of the silicon wafer 10 is 30 µm-300 µm, for example, 30 um, 40 um, 50 um, 60 um, 70 um, 80 um, 90 um, 100 um, 150 um, 200 um, 250 um, or 300 um. Therefore, a too low concentration of a photogenerated carrier caused by the too thin silicon wafer 10 can be avoided, and the too high cost of a battery caused by the too thick silicon wafer 10 can also be avoided.

Specifically, "the conduction type of the central region 11 being the N type" means that the conduction type shown by the central region 11 is the N type. However, this does not represent a limitation on a type of doping elements in the central region 11.

Further, in some implementations, the central region 11 does not include a P-type doping element, but includes an N-type doping element, such that the conduction type of the central region 11 is shown as N-type. In some other embodiments, the central region 11 also includes the P-type doping element and the N-type doping element, and a concentration of the N-type doping element is greater than a concentration of the P-type doping element, such that the conduction type of the central region 11 is shown as N-type.

Specifically, "the conduction type of the corner edge region 12 being the P type" means that the conduction type shown by the corner edge region 12 is the P type. However, this does not represent a limitation on a type of doping elements in the corner edge region 12.

Further, in some implementations, the corner edge region 12 does not include an N-type doping element, but includes a P-type doping element, such that the conduction type of the corner edge region 12 is shown as P-type. In some other embodiments, the corner edge region 12 also includes the P-type doping element and the N-type doping element, and a concentration of the P-type doping element is greater than a concentration of the N-type doping element, such that the conduction type of the central region 11 is shown as P-type.

### Embodiment 2

In some implementations, a doping element of the central region 11 includes an N-type doping element, and the N-type doping element includes at least one element in a fifth main group element and a sixth main group element.

Specifically, the fifth main group element includes nitrogen, phosphorus, arsenic, antimony, and bismuth.

Specifically, the sixth main group element includes oxygen, sulfur, selenium, tellurium, and polonium.

That is to say, the doping element of the central region 11 includes at least one of nitrogen, phosphorus, arsenic, antimony, bismuth, oxygen, sulfur, selenium, tellurium, or polonium. Therefore, various doping elements are provided, such that the doping elements in the central region 11 are more flexible, and can adopt to more actual production scenarios.

In some examples, the doping elements of the central region 11 include oxygen, nitrogen, phosphorus, and arsenic. In some other examples, the doping elements of the central region 11 include oxygen and phosphorus, which are not limited herein.

### Embodiment 3

In some implementations, a doping element of the corner edge region 12 includes a P-type doping element, and the P-type doping element includes at least one element in a third main group element.

Specifically, the third main group element includes boron, aluminum, gallium, indium, and thallium.

That is to say, the doping element of the corner edge region 12 includes at least one of boron, aluminum, gallium, indium, or thallium. Therefore, various doping elements are provided, such that the doping elements in the corner edge region 12 are more flexible, and can adopt to more actual production scenarios.

In some examples, the doping elements of the corner edge region 12 include boron and aluminum. In some other examples, the doping elements of the corner edge region 12 include boron, which are not limited herein.

### Embodiment 4

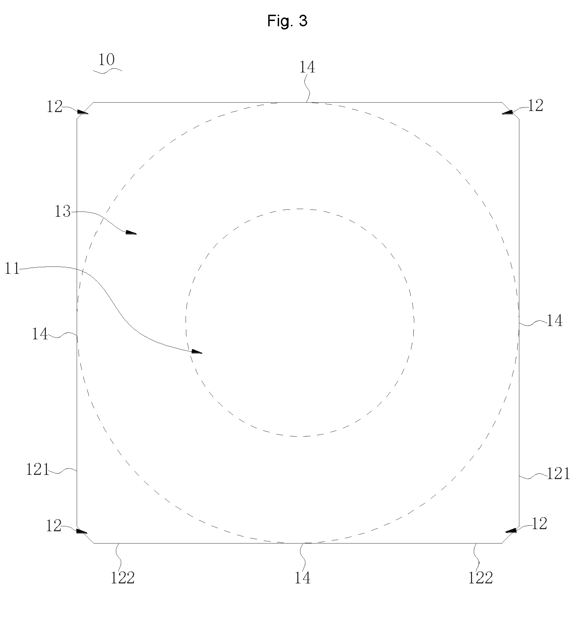

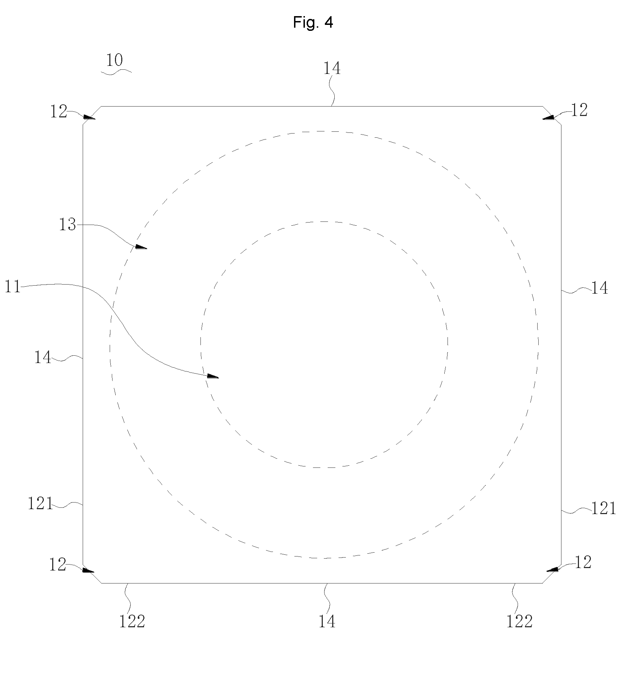

Referring to Fig. 3 and Fig. 4, in some implementations, the silicon wafer 10 includes a side edge region 14. The side edge region 14 is located between two adjacent corner edge regions 12, and a conduction type of the side edge region 14 is a P type.

Therefore, the conduction type of the corner edge region 12 is the P type, and the conduction type of the side edge region 14 between the two adjacent side edge regions 12 is also the P type, such that the side edge region 14 of the silicon wafer 10 can also withstand copper ion contamination, and compounding caused by contamination of copper ions to an edge of the silicon wafer 10 is further reduced, thereby improving photoelectric conversion efficiency.

Specifically, the side edge region 14 refers to a space region that extends from a cutting surface of a side length of the silicon wafer 10 to the center line of the silicon wafer 10. It can be understood that, a cross section of a silicon rod is in a circular shape, and the silicon wafer 10 forms a square, such that it is necessary to cut the silicon rod to form the cutting surface at the side length of the square.

Further, as described above, the center line forms the central point on the two surfaces of the silicon wafer 10 in the thickness direction. In the thickness direction of the silicon wafer 10, the side edge region 14 extends from an edge line of the side length of the silicon wafer 10 to the central point, as shown in Fig. 3 and Fig. 4. That is to say, the side edge region 14 is not only formed on the surface of the silicon wafer 10; and the side edge region 14 is the space region having a thickness.

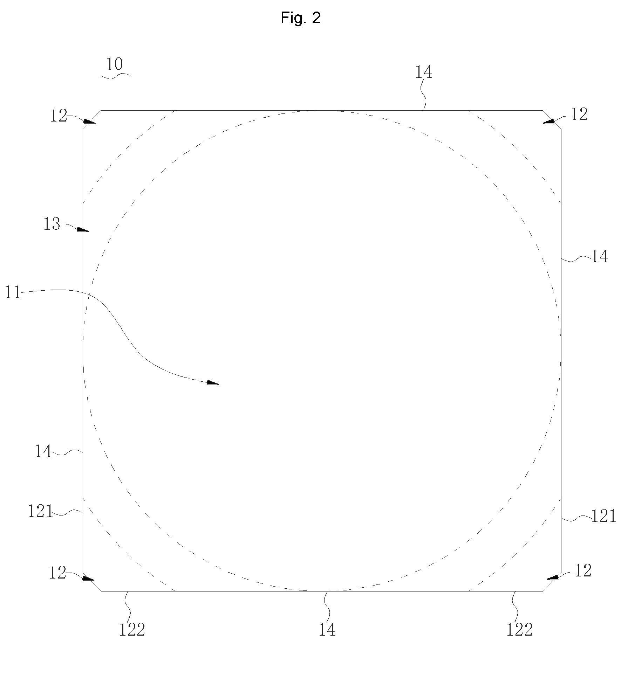

It can be understood that, in some implementations, the side edge region 14 is a region that is between the corner edge regions 12 on two sides, which is connected to the corner edge regions12 on the two sides, as shown in Fig. 4. In some other embodiments, the side edge region 14 is a boundary point that is between the corner edge regions 12 on the two sides, as shown in Fig. 3. In some other embodiments, the side edge region 14 is a long side of the silicon wafer 10 that is between the corner edge regions 12 on the two sides, as shown in Fig. 1 and Fig. 2.

### Embodiment 5

Referring to Fig. 1 and Fig. 2, in some implementations, the central region 11 has a circular surface in a thickness direction of the silicon wafer 10, a center of circle is a central point of the silicon wafer 10, and a radius is 1/5-1/2 of a side length of the silicon wafer 10, for example, 0.2, 0.25, 0.3, 0.35, 0.4, 0.45, 0.48, or 0.5.

Therefore, a size of the central region 11 is within an appropriate range, a small range of PN junctions formed in the silicon wafer 10 and a poor field passivation effect caused by a too small size can be avoided, and a small range of the corner edge region 12 due to a too large size and a poor effect of compounding caused by reducing copper ion contamination to the edge of the silicon wafer 10 can also be reduced.

### Embodiment 6

Referring to Fig. 1, Fig. 2, and Fig. 3, in some implementations, the corner edge region 12 includes a first corner side 121 and a second corner side 122, a length d1 of the first corner side 121 is 1/100-1/2 of a side length d0 of the silicon wafer 10, and a length d2 of the second corner side 122 is 1/100-1/2 of the side length d0 of the silicon wafer 10.

Therefore, the lengths of two corner sides of the corner edge region 12 are within an appropriate range, so as to cause the corner edge region 12 to be within an appropriate range, such that the poor effect of compounding caused by reducing copper ion contamination to the edge of the silicon wafer 10 caused by the corner edge region 12 being too small can be avoided, and the small range of the PN junctions formed in the silicon wafer 10 and the poor field passivation effect caused by the corner edge region 12 being too large can also be avoided.

Specifically, the first corner side 121 and the second corner side 122 respectively refer to portions of the corner edge region 12 of the long side of the silicon wafer 10. It can be understood that, the long side of the silicon wafer 10 does not include an arc-shaped side of a rounded corner or chamfer, but refers to long sides on two ends of the rounded corner or chamfer.

Specifically, a length of the first corner side 121 is, for example, 0.01, 0.08, 0.1, 0.15, 0.2, 0.25, 0.3, 0.35, 0.4, 0.45, or 0.5 of the side length of the silicon wafer 10.

Specifically, a length of the second corner side 122 is, for example, 0.01, 0.08, 0.1, 0.15, 0.2, 0.25, 0.3, 0.35, 0.4, 0.45, or 0.5 of the side length of the silicon wafer 10.

In some implementations, the length of the first corner side 121 and the length of the second corner side 122 are the same. In some implementations, the length of the first corner side 121 and the length of the second corner side 122 are different.

It can be understood that, when the lengths of the first corner side 121 and the second corner side 122 are 1/2 of the side length of the silicon wafer 10, the conduction types of all outer sides of the silicon wafer 10 are all P types, as shown in Fig. 3 and Fig. 4.

### Embodiment 7

Referring to Fig. 1, in some implementations, a ratio of resistivity of the corner edge region 12 to resistivity of the central region 11 is greater than or equal to 1.2, for example, 1.2, 1.5, 1.8, 2, 3, 4, 7, 8, or the like.

Therefore, the resistivity of the corner edge region 12 is greater than the resistivity of the central region 11, facilitating reduction of compounding, thereby improving conversion efficiency. It can be understood that, the resistivity of the corner edge region 12 is greater than the resistivity of the central region 11, it means that a P-type doping concentration of the corner edge region 12 is lower than that of the central region 11, such that P-type doping elements can be reduced in the corner edge region 12, for example, three group elements, so as to reduce compounding pairs formed by the three group elements of the corner edge region 12 and oxygen and compounding caused by the doping elements themselves, thereby improving conversion efficiency.

### Embodiment 8

Referring to Fig. 1, in some implementations, resistivity of the central region 11 is greater than or equal to 10 Ω▪cm, for example, 10 Ω▪cm, 13 Ω▪cm, 50 Ω▪cm, 100 Ω▪cm, 108 Ω▪cm, 191 Ω▪cm, 120 Ω▪cm, 203 Ω▪cm, 711 Ω▪cm, or the like.

Therefore, by causing the resistivity of the central region 11 to be within an appropriate range, a higher central oxygen content and a higher concentration of oxygen donor concentration generated as a result of a small resistivity of the central region 11 can be avoided, thereby preventing oxygen precipitation easily formed during the manufacturing of cells from affecting cell efficiency and yield.

### Embodiment 9

Referring to Fig. 1, in some implementations, resistivity of the corner edge region 12 is greater than or equal to 100 Ω▪cm, for example, 100 Ω▪cm, 110 Ω▪cm, 150 Ω▪cm, 200 Ω▪cm, 483 Ω▪cm, 1059 Ω▪cm, 3523 Ω▪cm, 947 Ω▪cm, 1512 Ω▪cm, or the like.

Therefore, by causing the resistivity of the corner edge region 12 to be within an appropriate range, the resistivity of the corner edge region 12 can be prevented from being too small, and the resistivity of the corner edge region 12 can be further increased by controlling a reduction rate of an acceptor doping concentration during crystal pulling.

### Embodiment 10

Referring to Fig. 1, in some implementations, an acceptor impurity concentration of the corner edge region 12 is less than an acceptor impurity concentration of the central region 11, and is less than a donor impurity concentration of the central region 11.

Therefore, the compounding caused by copper contamination can be further reduced, and the photoelectric conversion efficiency of the solar cell manufactured based on the silicon wafer 10 is improved.

Specifically, the acceptor impurity refers to the P-type doping element. The donor impurity refers to the N-type doping element.

It can be understood that, since the acceptor impurity concentration of the corner edge region 12 is less than the acceptor impurity concentration of the central region 11, the P-type doping elements can be reduced in the corner edge region 12, for example, three group elements, so as to reduce compounding pairs formed by the three group elements of the corner edge region 12 and oxygen and compounding caused by the doping elements themselves, thereby improving conversion efficiency.

It can be understood that, since the acceptor impurity concentration of the central region 11 is less than the donor impurity concentration of the central region 11, the central region 11 is represented as N-type.

### Embodiment 11

Referring to Fig. 1, in some implementations, a ratio of an acceptor impurity concentration of the central region 11 to an acceptor impurity concentration of the corner edge region 12 is 1.01-10, for example, 1.01, 1.02, 1.05, 1.1, 1.5, 1.8, 2, 3, 5, 8, 9, or 10.

Therefore, by causing the ratio of the acceptor impurity concentration of the central region 11 to the acceptor impurity concentration of the corner edge region 12 within an appropriate range, a relatively flat crystal interface, a relatively slow pulling speed, and a low yield caused by the ratio being too small can be avoided, and the crystal interface being more concave to a melt, large thermal stress, and easy wire breakage into polycrystalline caused by the ratio being too large can also be avoided.

### Embodiment 12

Referring to Fig. 1, in some implementations, an acceptor impurity concentration of the corner edge region 12 is less than or equal to 10¹⁵ atoms/cm³, for example, 1×10¹⁵ atoms/cm³, 0.8×10¹⁵ atoms/cm³, 0.5×10¹⁵ atoms/cm³, 0.1×10¹⁵ atoms/cm³, or the like.

Therefore, by causing the acceptor impurity concentration of the corner edge region 12 to be within an appropriate range, the compounding pairs formed with oxygen and more compounding caused by the doping elements themselves caused by a too large acceptor impurity concentration of the corner edge region 12 can be avoided, thereby improving conversion efficiency.

### Embodiment 13

Referring to Fig. 1, Fig. 2, and Fig. 3, in some implementations, the silicon wafer 10 includes a transition region 13. The transition region 13 is located between the central region 11 and the corner edge region 12, resistivity of the transition region 13 is greater than resistivity of the central region 11, and the resistivity of the transition region 13 is greater than resistivity of the corner edge region 12.

Therefore, a PIN junction can be formed in the silicon wafer 10 to reduce the compounding of direct PN contacts, and after the solar cell is manufactured, a better field passivation effect can be formed in the solar cell, thereby facilitating carrier transport.

Specifically, that the transition region 13 is located between the central region 11 and the corner edge region 12 means that the transition region 13 separates the central region 11 from the corner edge region 12. It can be understood that, the transition region 13 can realize the transition of the concentration of the doping elements between the central region 11 and the corner edge region 12. Herein, the donor concentration (e.g., an oxygen donor) is equivalent to the acceptor concentration, and the transition of the conduction type can also be realized.

### Embodiment 14

Referring to Fig. 1, Fig. 2, and Fig. 3, in some implementations, resistivity of the transition region 13 is greater than or equal to 1000 Ω▪cm, The resistivity of the transition region 13 is, for example, 1000 Ω▪cm, 1010 Ω▪cm, 1100 Ω▪cm, 1500 Ω▪cm, 1800 Ω▪cm, 2000 Ω▪cm, 2010 Ω▪cm, 2100 Ω▪cm, 2500 Ω▪cm, or 2800 Ω▪cm.

Therefore, after the solar cell is manufactured, a surrounding field passivation effect can be further improved in the solar cell, thereby further improving carrier transport.

### Embodiment 15

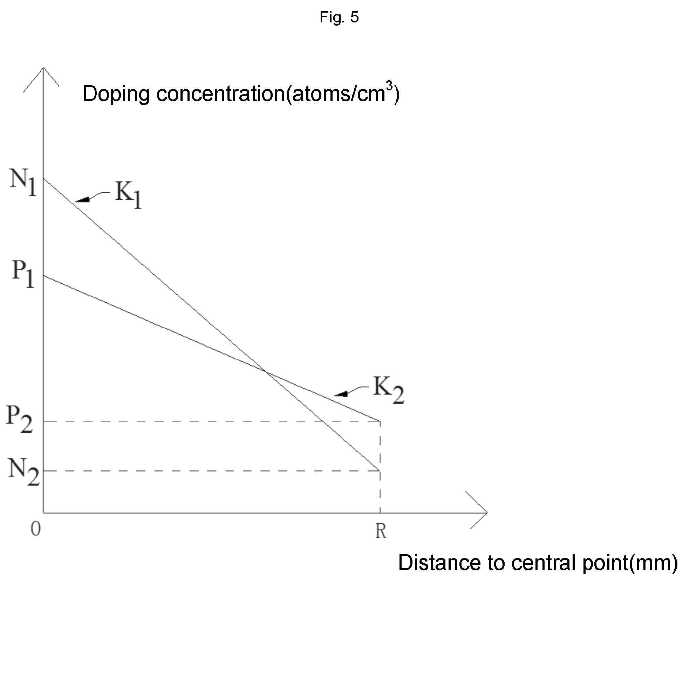

Referring to Fig. 5, in some implementations, doping elements of the central region 11 and the corner edge region 12 all includes P-type doping elements and N-type doping elements. A doping concentration of the N-type doping elements in the central region 11 is greater than a doping concentration of the P-type doping elements in the central region 11, and a doping concentration of the P-type doping elements in the corner edge region 12 is greater than a doping concentration of the N-type doping elements in the corner edge region 12. A slope absolute value K₁ of a concentration curve of the N-type doping element is greater than a slope absolute value K₂ of a concentration curve of the P-type doping element. A horizontal coordinate of the concentration curve of the N-type doping element is a distance between a test position of the silicon wafer 10 and a central point of the silicon wafer 10, and a vertical coordinate is a concentration of the N-type doping element in the test position; and a horizontal coordinate of the concentration curve of the P-type doping element is the distance between a test position and the central point of the silicon wafer 10, and a vertical coordinate is a concentration of the P-type doping element in the test position.

Therefore, since the slope absolute value K₁ of the concentration curve of the N-type doping element is greater than the slope absolute value K₂ of the concentration curve of the P-type doping element, the central point of the silicon wafer 10 can be outward, and the concentration of the N-type doping element falls more rapidly than the concentration of the P-type doping element, thereby ensuring that the conduction type of the central region 11 is the N type and the conduction type of the corner edge region 12 is the P type.

Specifically, in an example of Fig. 5, 0 corresponds to the central point of the silicon wafer 10, and R corresponds to a position in the silicon wafer 10 in which the distance to the central point is the maximum. It is apparent that, at the central point of the silicon wafer 10, the doping concentration N1 of the N-type doping element is greater than the doping concentration P1 of the P-type doping element, thereby ensuring that the conduction type of the central region 11 is the N type. It is apparent that, in the position in that silicon wafer 10 in which the distance to the central point is the maximum, that is, an outermost edge of the corner edge region 12, the doping concentration N₂ of the N-type doping element is less than the doping concentration P₂ of the P-type doping element, thereby ensuring that the conduction type of the outermost edge of the corner edge region 12 is the P type. It is apparent that, an intersection point of the concentration curve of the N-type doping element and the concentration curve of the P-type doping element is located in the central region 11, and in this case, the concentration of the N-type doping element is equal to that of the P-type doping element.

### Embodiment 16

Referring to Fig. 5, in some implementations, the slope absolute value of the concentration curve of the N-type doping element and the slope absolute value of the concentration curve of the P-type doping element meet the following formula. $\frac{2}{\sqrt{2} a} \left({N}_{1}-{P}_{1}\right) < {K}_{1} - {K}_{2} < \frac{32}{\sqrt{2} a} \left({N}_{1}-{P}_{1}\right) .$

Where a is a side length of the silicon wafer, N₁ is the doping concentration of the N-type doping element in the central region 11, P₁ is the doping concentration of the P-type doping element in the central region 11, K₁ is the slope absolute value of the concentration curve of the N-type doping element, and K₂ is the slope absolute value of the concentration curve of the P-type doping element.

In this way, by causing a difference value between the slope absolute value K₁ of the concentration curve of the N-type doping element and the slope absolute value K₂ of the concentration curve of the P-type doping element to be within an appropriate range, the too small range of the central region 11 caused by the difference value being too large can be avoided, and the too large range of the central region 11 caused by the difference value being too small or even there is no P-shaped corner edge region 12 in the silicon wafer can also be avoided.

### Embodiment 17

A solar cell in this embodiment of the present disclosure is manufactured based on the silicon wafer 10 in any one of Embodiments 1 to 16.

In the solar cell in this embodiment of the present disclosure, since the conduction type of the central region 11 of the silicon wafer 10 is the N type, and the conduction type of the corner edge region 12 is the P type, in some implementations, in a process of manufacturing a solar cell based on the silicon wafer 10, contamination of copper ions to an edge of the silicon wafer 10 can be withstood by using the P-shaped corner edge region 12, thereby reducing compounding caused by the contamination of the copper ions to the edge of the silicon wafer 10. Furthermore, in some implementations, a PN junction can be formed in the silicon wafer 10, and after the solar cell is manufactured, a better field passivation effect can be formed in the solar cell, thereby facilitating carrier transport. In this way, the photoelectric conversion efficiency of the solar cell manufactured based on the silicon wafer 10 is improved.

### Embodiment 18

A cell assembly in this embodiment of the present disclosure includes the solar cell in Embodiment 17.

In the cell assembly in this embodiment of the present disclosure, since the conduction type of the central region 11 of the silicon wafer 10 is the N type, and the conduction type of the corner edge region 12 is the P type, in a process of manufacturing a solar cell based on the silicon wafer 10, contamination of copper ions to an edge of the silicon wafer 10 can be withstood by using the P-shaped corner edge region 12, thereby reducing compounding caused by the contamination of the copper ions to the edge of the silicon wafer 10. Furthermore, a PN junction is formed in the silicon wafer 10, and after the solar cell is manufactured, a better field passivation effect can be formed in the solar cell, thereby facilitating carrier transport. In this way, the photoelectric conversion efficiency of the solar cell manufactured based on the silicon wafer 10 is improved.

In this embodiment, the plurality of solar cells in the cell assembly can be sequentially connected in series together to form a battery string, so as to realize series convergence output of currents, for example, the serial connection of battery pieces can be implemented by means of disposing a ribbon (a bus bar or an interconnection bar), a conductive backboard, etc.

It can be understood that, in such an embodiment, the cell assembly can further include a metal frame, a backboard, photovoltaic glass, and an adhesive film. The adhesive film can be filled between the front side and back side of the solar cell and the photovoltaic glass, or the adjacent battery pieces, etc. As a filler, the adhesive film can be a transparent colloid with good transmittance performance and aging resistance. For example, the adhesive film can use an EVA adhesive film or a POE adhesive film, which can be specifically selected according to actual situations, and is not limited herein.

In some implementations, the photovoltaic glass can be covered on the adhesive film of the front side of the solar cell. The photovoltaic glass is ultra-clear glass, which has high transmittance, high transparency, and excellent physical, mechanical, and optical properties. For example, the transmittance of the ultra-clear glass can reach over 92%, and the ultra-clear glass can protect the solar cell without affecting the efficiency of the solar cell as much as possible. Furthermore, the adhesive film can bond the photovoltaic glass and the solar cell together, and the presence of the adhesive film can perform sealed insulation and protection against water and moisture on the solar cell.

The backboard can be attached to the adhesive film on the back side of the solar cell. The backboard can protect and support the solar cell, and has reliable insulation, water resistance, and aging resistance. In some implementations, the backboard has various options, and usually is tempered glass, organic glass, an aluminum alloy TPT composite adhesive film, etc., which can specifically be designed according to specific situations, and is not limited herein. In some other embodiments, an integral body consisting of the backboard, the solar cell, the adhesive film, and the photovoltaic glass can be disposed on the metal frame. The metal frame, as a main external support structure of the entire cell assembly, performs stable support and mounting on the cell assembly, for example, the cell assembly can be mounted, through the metal frame, in a position required to be mounted.

### Embodiment 19

A photovoltaic system in this embodiment of the present disclosure includes the cell assembly in Embodiment 18.

In the photovoltaic system in this embodiment of the present disclosure, since the conduction type of the central region 11 of the silicon wafer 10 is the N type, and the conduction type of the corner edge region 12 is the P type, in some implementations, in a process of manufacturing a solar cell based on the silicon wafer 10, contamination of copper ions to an edge of the silicon wafer 10 can be withstood by using the P-shaped corner edge region 12, thereby reducing compounding caused by the contamination of the copper ions to the edge of the silicon wafer 10. Furthermore, in some implementations, a PN junction can be formed in the silicon wafer 10, and after the solar cell is manufactured, a better field passivation effect can be formed in the solar cell, thereby facilitating carrier transport. In this way, the photoelectric conversion efficiency of the solar cell manufactured based on the silicon wafer 10 is improved.

In this embodiment, the photovoltaic system can be applied to a photovoltaic power station such as a surface power station, a rooftop power station, a water surface power station, etc., or can also be applied to a device or an apparatus that uses solar energy for power generation, such as a user solar power supply, a solar street lamp, a solar car, a solar building, etc. Definitely, it can be understood that, the application scenarios of the photovoltaic system are not limited thereto, that is, the photovoltaic system can be used in all fields where solar energy is required for power generation. By using a photovoltaic power generation system network as an example, the photovoltaic system can include a photovoltaic array, a combiner box, and an inverter. In some implementations, the photovoltaic array is an array combination of a plurality of cell assemblies. For example, the plurality of cell assemblies can constitute a plurality of photovoltaic arrays. The photovoltaic array is connected to the combiner box. The combiner box can converge currents generated by the photovoltaic array, and the converged currents are converted into alternating currents required by the municipal power grid by passing through the inverter, and then are connected to the municipal power network, so as to realize solar power supply.

### Embodiment 20

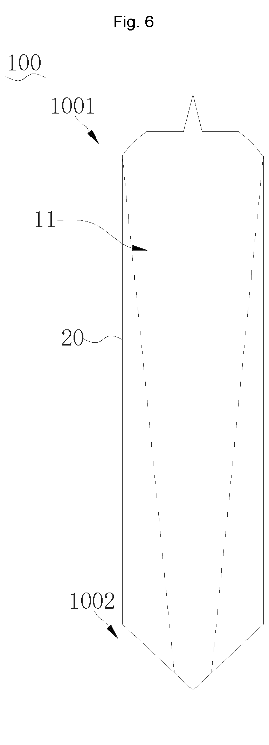

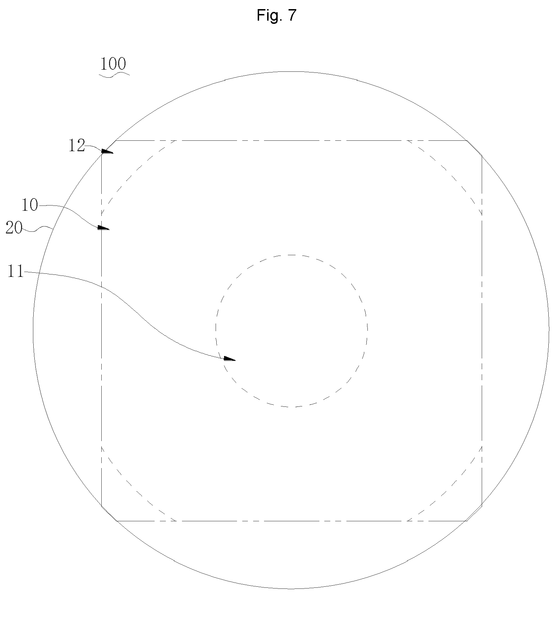

Referring to Fig. 6, Fig. 7, and Fig. 8, a silicon rod 100 in this embodiment of the present disclosure includes a central region 11 and a surface skin 20. A conduction type of the central region 11 is an N type, and a conduction type of the surface skin 20 is a P type. The silicon wafer 10 in any one of Embodiment 1 to 14 is formed by cutting the silicon rod 100.

In the silicon rod 100 of the embodiments of the present disclosure, since the conduction type of the central region 11 is the N type, and the conduction type of the surface skin 20 is the P type. Minority carrier lifetime is higher, the resistivity is uniform, and head and tail resistivity distribution of the silicon rod 100 does not need to be taken into consideration, such that complete pull-out of silicon materials in a crucible is facilitated, crystal pulling efficiency is higher, and a retention rate of the crucible is lower.

Furthermore, in the silicon wafer 10 formed by cutting the silicon rod 100, the conduction type of the central region 11 is the N type, and the conduction type of the corner edge region 12 is the P type, in some implementations, in a process of manufacturing a solar cell based on the silicon wafer 10, contamination of copper ions to an edge of the silicon wafer 10 can be withstood by using the P-shaped corner edge region 12, thereby reducing compounding caused by the contamination of the copper ions to the edge of the silicon wafer 10. Furthermore, in some implementations, a PN junction can be formed in the silicon wafer 10, and after the solar cell is manufactured, a better field passivation effect can be formed in the solar cell, thereby facilitating carrier transport. In this way, the photoelectric conversion efficiency of the solar cell manufactured based on the silicon wafer 10 is improved.

It can be understood that, since the silicon wafer 10 is formed by cutting the silicon rod 100, the central region 11 of the silicon rod 100 corresponds to the central region 11 of the silicon wafer 10. Explanations and descriptions can be cross-referenced.

Specifically, the surface skin 20 refers to an outer layer of the silicon rod 100.

### Embodiment 21

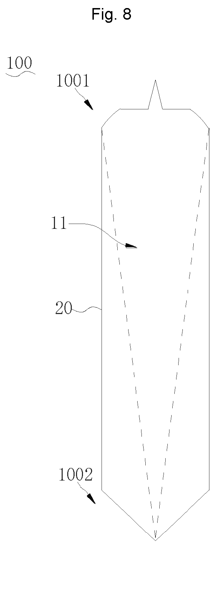

Referring to Fig. 6 and Fig. 8, in some implementations, the central region 11 is in a shape of a circular truncated cone or a cone, and in a direction from a head 1001 of the silicon rod 100 to a tail 1002 of the silicon rod 100, a cross-sectional area of the central region 11 decreases gradually.

In some implementations, at the head 1001 of the silicon rod 100, the conduction type of all regions is the N type. In some implementations, at the head 1001 of the silicon rod 100, the conduction type of some regions is the N type, and the conduction type of the rest of the regions is the P type. It can be understood that, when the silicon rod 100 is cut into a silicon wafer, the head 1001 of the silicon rod 100 does not need to be removed, just the silicon wafers in which the conduction type of all the regions cut from the head 1001 of the silicon rod 100 is the N type, and the silicon wafers 10 in which the conduction type of the central region 11 is the N type and the conduction type of the corner edge region 12 is the P type can still be used for manufacturing cells.

In some implementations, at the tail 1002 of the silicon rod 100, the conduction type of all regions is the P type. In some implementations, at the head 1001 of the silicon rod 100, the conduction type of some regions is the P type, and the conduction type of the rest of the regions is the N type. It can be understood that, when the silicon rod 100 is cut into a silicon wafer, the tail 1002 of the silicon rod 100 does not need to be removed, just the silicon wafers in which the conduction type of all the regions cut from the tail 1002 of the silicon rod 100 is the P type, and the silicon wafers 10 in which the conduction type of the central region 11 is the N type and the conduction type of the corner edge region 12 is the P type can still be used for manufacturing cells.

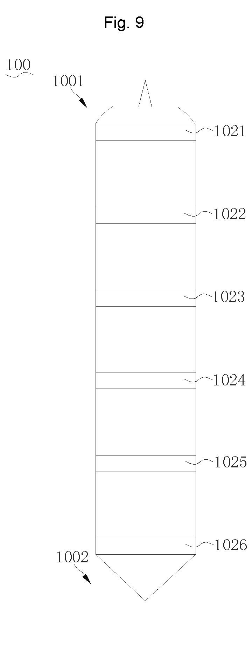

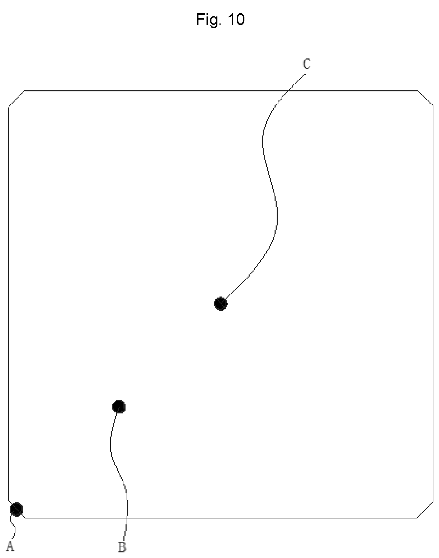

Referring to Fig. 9 and Fig. 10, in some examples, 5 test pieces are cut from the silicon rod 100, which are respectively recorded as a first test piece 1021, a second test piece 1022, a third test piece 1023, a fourth test piece 1024, a fifth test piece 1025, and a sixth test piece 1026. A corner edge point A, a transition region point B, and a central point C on each test piece are used as detection points for detection, so as to obtain results in Table 1 and Table 2 below.

**Table 1**

| | First test piece 1021 | | Second test piece 1022 | | Third test piece 1023 | |
|---|---|---|---|---|---|---|
| Detecting point | Resistivity | P/N type | Resistivity | P/N type | Resistivity | P/N type |
| A | 86 | N type | 483 | P type | 1059 | P type |
| B | 24 | N type | 171 | N type | 159 | N type |
| C | 23 | N type | 191 | N type | 203 | N type |

**Table 2**

| | Fourth test piece 1024 | | Fifth test piece 1025 | | Sixth test piece 1026 | |
|---|---|---|---|---|---|---|
| Detecting point | Resistivity | P/N type | Resistivity | P/N type | Resistivity | P/N type |
| A | 3523 | P type | 947 | P type | 1512 | P type |
| B | 78 | N type | 95 | N type | 517 | N type |
| C | 120 | N type | 108 | N type | 711 | N type |

It is apparent that, the second test piece 1022, the third test piece 1023, the fourth test piece 1024, the fifth test piece 1025, and the sixth test piece 1026 are silicon wafers 10 in the embodiments of the present disclosure.

Cells manufactured based on silicon wafers in the related art are used as comparative examples below and compared with the cells manufactured using the same process based on the silicon wafers 10 of the present disclosure.

The cell manufactured based on a silicon wafer in the related art is used as Comparative example 1. The conduction types of a central region and a corner edge region of the silicon wafer both are N types. Based on the cell manufactured based on the silicon wafer, an open circuit voltage is 0.731 V, a short-circuit current is 42.7 mA/cm², a fill factor is 0.843, and conversion efficiency is 26.31%.

The cell manufactured based on another silicon wafer in the related art is used as Comparative example 2. The conduction types of a central region and a corner edge region of the silicon wafer both are P types. Based on the cell manufactured based on the silicon wafer, an open circuit voltage is 0.721 V, a short-circuit current is 41.8 mA/cm², a fill factor is 0.841, and conversion efficiency is 25.35%.

For the silicon wafer 10 in some examples of the present disclosure, the conduction types of the central region 11 is the N type, the conduction types of the corner edge region 12 is the P type, the central region 11 uses a central point of the silicon wafer as the center of circle, and a radius is 1/5 of a side length of the silicon wafer. Based on the cell manufactured based on the silicon wafer 10, an open circuit voltage is 0.743 V, a short-circuit current is 42.7 mA/cm², a fill factor is 0.846, and conversion efficiency is 26.84%.

For the silicon wafer 10 in some examples of the present disclosure, the conduction types of the central region 11 is the N type, the conduction types of the corner edge region 12 is the P type, the central region 11 uses a central point of the silicon wafer as the center of circle, and a radius is 1/2 of a side length of the silicon wafer. Based on the cell manufactured based on the silicon wafer 10, an open circuit voltage is 0.747 V, a short-circuit current is 42.8 mA/cm², a fill factor is 0.851, and conversion efficiency is 27.21%.

It is apparent that, compared to the cells manufactured using the same process based on the silicon wafers in the related art, the solar cells manufactured by the silicon wafers 10 of the embodiments of the present disclosure have a higher open circuit voltage, a flat or higher short-circuit current, a higher fill factor, and significantly-improved conversion efficiency.

In the description of the specification, descriptions of the terms "some embodiments," "exemplary embodiment", "example," "specific example," or "some examples", mean that specific features, structures, materials, or characteristics described with reference to the implementations or examples are included in at least one implementation or example of the present disclosure. In this specification, schematic representations of the above terms do not necessarily refer to the same embodiment or example. In addition, the described particular features, structures, materials or characteristics can be combined in any suitable manner in any one or more embodiments or examples.

Furthermore, the above are merely preferred embodiments of the present disclosure, but are not intended to limit the present disclosure. Any modification, equivalent replacement, improvement, or the like made within the spirit and principle of the present disclosure should fall within the protection scope of the present disclosure.

## Claims

1. A silicon wafer, comprising a central region and a corner edge region, wherein a conduction type of the central region is an N type, and a conduction type of the corner edge region is a P type.

2. The silicon wafer according to claim 1, wherein a doping element of the central region comprises an N-type doping element, and the N-type doping element comprises at least one element in a fifth main group element and a sixth main group element.

3. The silicon wafer according to claim 1, wherein a doping element of the corner edge region comprises a P-type doping element, and the P-type doping element comprises at least one element in a third main group element.

4. The silicon wafer according to claim 1, comprising a side edge region, wherein the side edge region is provided between two adjacent corner edge regions, and a conduction type of the side edge region is a P type.

5. The silicon wafer according to claim 1, wherein a surface of the central region in a thickness direction of the silicon wafer is a circle, a center of the circle is a central point of the silicon wafer, and a radius of the circle is 1/5-1/2 of a side length of the silicon wafer.

6. The silicon wafer according to claim 1, wherein the corner edge region comprises a first corner side and a second corner side, a length of the first corner side is 1/100-1/2 of a side length of the silicon wafer, and a length of the second corner side is 1/100-1/2 of the side length of the silicon wafer.

7. The silicon wafer according to claim 1, wherein a ratio of resistivity of the corner edge region to resistivity of the central region is greater than or equal to 1.2.

8. The silicon wafer according to claim 1, wherein resistivity of the central region is greater than or equal to 10 Ω▪cm.

9. The silicon wafer according to claim 1, wherein resistivity of the corner edge region is greater than or equal to 100 Ω▪cm.

10. The silicon wafer according to claim 1, wherein an acceptor impurity concentration of the corner edge region is less than an acceptor impurity concentration of the central region, and is less than a donor impurity concentration of the central region.

11. The silicon wafer according to claim 1, wherein a ratio of an acceptor impurity concentration of the central region to an acceptor impurity concentration of the corner edge region is 1.01-10.

12. The silicon wafer according to claim 1, wherein an acceptor impurity concentration of the corner edge region is less than or equal to 10¹⁵ atoms/cm³.

13. The silicon wafer according to claim 1, comprising a transition region, wherein the transition region is provided between the central region and the corner edge region, resistivity of the transition region is greater than resistivity of the central region, and the resistivity of the transition region is greater than resistivity of the corner edge region.

14. The silicon wafer according to claim 13, wherein the resistivity of the transition region is greater than or equal to 1000 Ω▪cm.

15. The silicon wafer according to claim 1, wherein doping elements of the central region and the corner edge region all comprises P-type doping elements and N-type doping elements, a doping concentration of the N-type doping elements in the central region is greater than a doping concentration of the P-type doping elements in the central region, and a doping concentration of the P-type doping elements in the corner edge region is greater than a doping concentration of the N-type doping elements in the corner edge region;
a slope absolute value of a concentration curve of the N-type doping element is greater than a slope absolute value of a concentration curve of the P-type doping element;
a horizontal coordinate of the concentration curve of the N-type doping element is a distance between a test position of the silicon wafer and a central point of the silicon wafer, and a vertical coordinate is a concentration of the N-type doping element in the test position; and a horizontal coordinate of the concentration curve of the P-type doping element is the distance between a test position and the central point of the silicon wafer, and a vertical coordinate is a concentration of the P-type doping element in the test position.

16. The silicon wafer according to claim 15, wherein the slope absolute value of the concentration curve of the N-type doping element and the slope absolute value of the concentration curve of the P-type doping element meet the following formula: $\frac{2}{\sqrt{2} a} \left({N}_{1}-{P}_{1}\right) < {K}_{1} - {K}_{2} < \frac{32}{\sqrt{2} a} \left({N}_{1}-{P}_{1}\right) ;$ wherein a is a side length of the silicon wafer, N₁ is the doping concentration of the N-type doping element in the central region, P₁ is the doping concentration of the P-type doping element in the central region, K₁ is the slope absolute value of the concentration curve of the N-type doping element, and K₂ is the slope absolute value of the concentration curve of the P-type doping element.

17. A solar cell, manufactured based on the silicon wafer according to any one of claims 1 to 16.

18. A cell assembly, comprising the solar cell according to claim 17.

19. A photovoltaic system, comprising the cell assembly according to 18.

20. A silicon rod, comprising a central region and a surface skin, wherein a conduction type of the central region is an N type, and a conduction type of the surface skin is a P type, and the silicon wafer according to any one of claims 1 to 16 is formed by cutting the silicon rod.

21. The silicon rod according to claim 20, wherein the central region is in a shape of a circular truncated cone or a cone, and in a direction from a head of the silicon rod to a tail of the silicon rod, a cross-sectional area of the central region decreases gradually.
